Europäisches Patentamt

(19) European Patent Office

Office européen des brevets

(11) Veröffentlichungsnummer: **0 029 554**
**B1**

(12) **EUROPÄISCHE PATENTSCHRIFT**

(45) Veröffentlichungstag der Patentschrift:
28.09.83

(21) Anmeldenummer: **80107064.0**

(22) Anmeldetag: **14.11.80**

(51) Int. Cl.³: **H 01 L 27/08, H 01 L 29/78**

54 Verfahren zum Herstellen von MNOS-Speichertransistoren mit sehr kurzer Kanallänge in Silizium-Gate-Technologie.

(30) Priorität: **23.11.79 DE 2947350**

(43) Veröffentlichungstag der Anmeldung:
**03.06.81 Patentblatt 81/22**

(45) Bekanntmachung des Hinweises auf die Patenterteilung:
**28.09.83 Patentblatt 83/39**

(84) Benannte Vertragsstaaten:
**FR GB**

(56) Entgegenhaltungen:
EP-A-0 003 231
DE-A-2 754 066
FR-A-2 379 168
IBM TECHNICAL DISCLOSURE BULLETIN, Band
21, August 1978, New York, US, V. L. RIDEOUT:
»Polysilicon-gate DMOSFET with low resistance
diffused interconnection lines«, Seiten 1264—1267
IBM TECHNICAL DISCLOSURE BULLETIN, Band
21, Juli 1978, Nr. 2, New York, US, G. M. OLESZEK
et al.: »Ion-implanted high-voltage MOSFET«,
Seiten 681—682
IBM TECHNICAL DISCLOSURE BULLETIN, Band
20, September 1977, New York, US, B. L. CROW-
DER et al.: »DMOS FET with common field and
channel doping«, Seiten 1617—1621

(73) Patentinhaber: **SIEMENS AKTIENGESELLSCHAFT,**
**Berlin und München Wittelsbacherplatz 2,**
**D-8000 München 2 (DE)**

(72) Erfinder: **Jacobs, Erwin, Dr., Stieglitzweg 9,**
**D-8011 Vaterstetten (DE)**
Erfinder: **Schwabe, Ulrich, Dr., Grünwalder Strasse 40,**
**D-8000 München 90 (DE)**
Erfinder: **Takacs, Dezsö, Dipl.-Phys.,**
**Entenbachstrasse 16, D-8000 München 90 (DE)**

**JAPANESE JOURNAL OF APPLIED PHYSICS,**
**Band 18, Supplement 18-1, 1979, Proceedings of**
**the 10th conference on solid-state devices, Tokyo,**
**JP, Y. YATSUDA et al.: »n-channel Sigate MNOS**
**device for high speed EAROM«, Seiten 21—26**
**TECHNICAL DIGEST 1977 INTERNATIONAL**
**ELECTRON DEVICES MEETING, 5.—7. Dezember**
**1977, Washington, DC, US, K. MURAKAMI et al.:**
**»Double ion-implanted DSAMOS-bipolar de-**
**vices«, Seiten 186—188**

Verfahren zum Herstellen von MNOS-Speichertransistoren mit sehr kurzer
Kanallänge in Silizium-Gate-Technologie

Die vorliegende Patentanmeldung betrifft ein Verfahren zum Herstellen von MNOS-Speichertransistoren mit sehr kurzer Kanallänge in Silizium-Gate-Technologie, bei dem in einem Halbleitersubstrat eines ersten Leitfähigkeitstyps Source- und Drain-Zonen von MNOS- und MOS-Bauelementen vom zweiten, zum ersten entgegengesetzten Leitfähigkeitstyp vorgesehen sind und die Ränder der Gateelektroden, bezogen auf die Ebene der Substratoberfläche, senkrecht und selbstjustierend über den Rändern der Source- und Drain-Zonen liegen, wobei die im Substrat erzeugten Source- und Drain-Zonen unter Verwendung der Gateelektroden als Implantationsmaske durch Ionenimplantation hergestellt werden.

Ein derartiges Verfahren ist aus dem Japanese Journal of Applied Physics, vol. 18, Supplement 18-1, 1979, S. 21 – 26, bekannt.

Die Wirkungsweise eines MNOS-Speichertransistors (MNOS = metal-nitride-oxide-semiconductor) beruht darauf, daß in einem MNOS-Feldeffekttransistor der für eine vorgegebene Gatespannung definierte Leitungszustand bzw. die Einsatzspannung des Transistors durch räumlich festsitzende Ladungen in der Gate-Doppelisolationsschicht bzw. in der Siliziumnitridschicht bleibend verändert wird. Beim Programmieren werden in den adressierten Transistoren durch einen Spannungsimpuls negative Ladungen an der Grenzfläche Nitrid-Oxid bzw. im Nitrid angelagert, die diese Transistoren permanent sperrend machen. Die Ladungen können durch einen Impuls umgekehrter Polarität oder andere Löschverfahren wieder abgebaut werden. Ein solches anderes Verfahren ist das »Kurzkanallöschen«, bei dem an das Source- und Drain-Gebiet ein positiver Spannungsimpuls gelegt wird, während Substrat und Gate auf Erdpotential liegt.

Die Herstellung höchst integrierter Schaltkreise (VLSI = very large scale integration-Technologie) erfordert dünne Gateoxide (kleiner 0,5 μm). Als Folge dieser Forderung erniedrigt sich die Lawinendurchbruchsspannung am drainseitigen pn-Übergang. Für das Kurzkanallöschen von Siliziumdioxid/Siliziumnitrid-Doppelisolatorschicht-Speicherelementen (MNOS-Transistoren) wird der Löschvorgang (avalanche-punchthrough-Durchbruch) erschwert, da die Transistoren bereits vor Erreichen der Löschspannung an den pn-Übergängen des Source-Drain-Gebietes durchbrechen.

Zur Verringerung der Toleranzen und damit zur Verkürzung der Kanallänge sucht man nach selbstjustierenden Verfahren. Ein solches Verfahren für die Herstellung einer MNOS-Speicherzelle ist aus der DE-A-2 918 888.3 zu entnehmen. Dabei wird die effektive Kanallänge dadurch eingestellt, daß die Gate-Elektrode in zwei, verschieden ansteuerbare, einander überlagernde Elektroden (dual gate) aufgeteilt ist und der Anschluß der Gateelektroden über selbstjustierende, überlappende Kontakte hergestellt ist. Die Ränder der über der ersten Gateelektrode (Speichergate) liegenden zweiten Gateelektrode liegen, bezogen auf die Ebene der Substratoberfläche senkrecht und selbstjustierend über den Rändern der Source- und Drainzone. Die Speichernitridschicht erstreckt sich über das Gebiet der Kanalzone hinaus, teilweise auf die Source- und Drainzone.

Die Erfindung löst das Problem der Herstellung von MNOS-Transistoren mit sehr kurzer Kanallänge in der VLSI-Technologie auf eine andere, einfachere und damit weniger aufwendigere Weise und ist durch ein Verfahren der eingangs genannten Art mit folgendem Ablauf der Verfahrensschritte gekennzeichnet:

a) Erzeugung einer als Tunneloxid wirkenden Siliziumoxidschicht auf einem, zur Trennung der aktiven Transistorbereiche mit strukturiertem, als Feldoxid wirkenden $SiO_2$-Schichten versehenen Siliziumsubstrat eines ersten Leitfähigkeitstyps,

b) ganzflächige Abscheidung einer als Speicherschicht dienenden Siliziumnitridschicht,

c) Strukturierung der Speichernitridschicht im Bereich des Speichertransistors,

d) Durchführung einer ganzflächigen Oxidation zur Erzeugung des Gateoxids und einer Oxinitridschicht auf dem Speichernitrid,

e) Abscheidung einer Polysiliziumschicht und Strukturierung der Polysiliziumschicht als Gateelektroden im Bereich des Speicher- und des MOS-Transistors,

f) Durchführung einer ersten Fotolacktechnik zur Erzeugung einer Implantationsmaske über den Feldoxidbereichen und über der Gateelektrode des Speichertransistors,

g) Durchführung einer ersten Implantation mit Ionen des ersten Leitfähigkeitstyps,

h) Durchführung einer Diffusion nach Ablösung der Fotolackmaske zur Ausbildung der durch die erste Implantation erzeugten Gebiete des ersten Leitfähigkeitstyps,

i) Durchführung einer zweiten Fotolacktechnik zur Erzeugung einer Implantationsmaske im Bereich des Gateoxids für den MOS-Transistor und des Gateoxids mit der Nitrid- bzw. Oxinitridschicht des Speichertransistors,

j) Durchführung einer Doppelimplantation von Ionen des zweiten Leitfähigkeitstyps, wobei zuerst eine Implantation mit niedriger Energie zur Erzeugung von als Source/Drain-Zonen wirkenden $n^+$-Gebieten und dann nach Ablösung der Fotolackmaske eine weitere Implantation mit höherer Energie zur Erzeugung ebenfalls als Source/Drain-Zonen wirkender n-Gebiete und eines Kurzkanals des MNOS-Transistors durchgeführt wird,

k) Abscheidung des Zwischenoxids, Erzeugung der Kontaktlöcher und Herstellung der Metallkontakte in bekannter Weise.

Die Erfindung macht sich dabei die aus dem Stand der Technik [(1) I. Ohkura et al., Proc. 8th Conference on Solid St. Dev., Tokyo 1976, Jap. J. Appl. Phys. Suppl., 16, 167−171 (1977), (2) I. Ohkura et al., IEEE Transact. Electr. Dev., ED-26, 430−435 (1979)] bekannte Herstellungsweise normaler Transistoren kurzer Kanallänge in VLSI-Technologie mit selbstjustierten, doppeltdiffundierten Sorce-Drain-Gebieten zunutze und erhält durch Anwendung von drei zusätzlichen Masken zum normalen Silizium-Gate-Prozeß in gleichzeitiger Herstellung MNOS-Transistoren mit effektiven Kanallängen <1 µm, symmetrische und asymmetrische, doppeldiffundierte, selbstjustierte MOS-Transistoren und normale MOS-Transistoren auf dem gleichen Chip. Dadurch können einerseits alle Vorteile des Kurzkanallöschens für die Speichertransistoren, andererseits die hohe Spannungsfestigkeit der doppelt diffundierten, selbstjustierenden MOS-Transistoren für die peripheren Schaltkreise voll genutzt werden.

Zur Erhöhung der Sicherheit bei der Vermeidung von Kurzschlüssen wird die Nitridschicht der MNOS-Speichertransistoren so strukturiert, daß sie sich über das Gebiet der Kanalzone hinaus teilweise auf das Gebiet der Source- und Drainzone erstreckt.

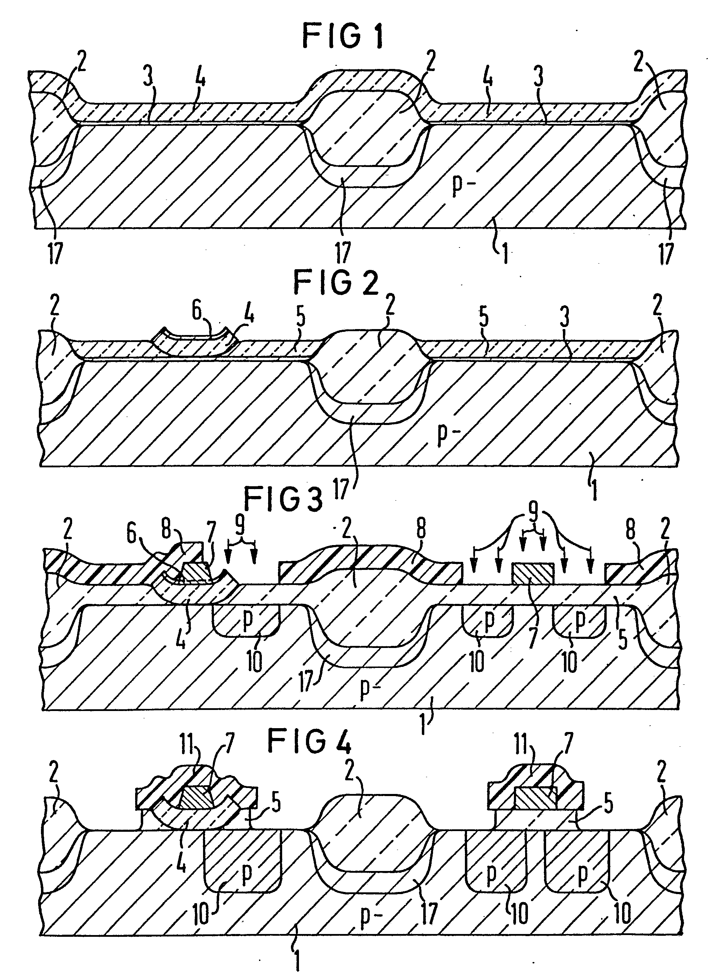

Weitere Einzelheiten sollen anhand eines Ausführungsbeispiels und der Fig. 1 bis 6 bei der Herstellung eines n-Kanal-Silizium-Gate-MNOS-Speichertransistors noch näher erläutert werden. In allen Figuren gelten für gleiche Teile die gleichen Bezugszeichen.

In Fig. 1 wird von einem p-dotierten (100)-orientierten Silizium-Substrat 1 ausgegangen, welches durch ein Isoplanarverfahren − auch LOCOS-(=local oxidation of silicon)-Verfahren genannt − mit strukturierten SiO$_2$-Schichten 2 (sogenanntes Feldoxid) zur Trennung der aktiven Transistorbereiche versehen ist. Bei diesem Verfahren wird, wie in der Figur nicht näher dargestellt ist, das p-dotierte Silizium-Substrat 1 zunächst mit einer 50 nm dicken SiO$_2$-Schicht und einer 100 nm dicken Silizium-Nitrid-Schicht versehen. Nach der Strukturierung und einer möglichen Feldimplantation 17 wird auf das Silizium-Substrat eine als Dickoxid wirkende 700 nm dicke SiO$_2$-Schicht 2 aufoxidiert. Im Anschluß daran wird die Silizium-Nitrid-Schicht wieder entfernt. In einem weiteren Verfahrensschritt wird dann ganzflächig eine 3 nm dicke, als Tunneloxid wirkende Silizium-Oxid-Schicht 3 abgeschieden und darauf die Speichernitridschicht 4 in einer Schichtdicke von 40 nm aufgebracht.

Diese Speichernitridschicht 4 wird, wie in Fig. 2 dargestellt ist, mittels Maskentechnik so strukturiert, daß sie im Bereich des Speichertransistors stehen bleibt. Im Anschluß daran wird die als Gateoxid 5 für den Nichtspeichertransistor wirkende, 50 nm dicke SiO$_2$-Schicht thermisch aufoxidiert, wobei der Bereich über der Siliziumnitridschichtoberfläche 4 in eine ca. 15 nm dicke Oxinitridschicht 6 übergeht.

Aus Fig. 3 ist eine Anordnung ersichtlich, bei der das im Anschluß an die Gateoxidation (5) aufgebrachte Poly-Silizium als Gateelektrode 7 strukturiert ist und unter Verwendung einer ersten Fototechnik (Fotolack 8) als Implantationsmaske für eine Borimplantation (siehe Pfeile 9) verwendet wird. Durch diese Implantation (9) entstehen bei einer Dosis von $2 \times 10^{12}$ bis $1 \times 10^{13}$ B$^+$cm$^{-2}$ und einer Implantationsenergie von 35 keV die p-dotierten Gebiete 10.

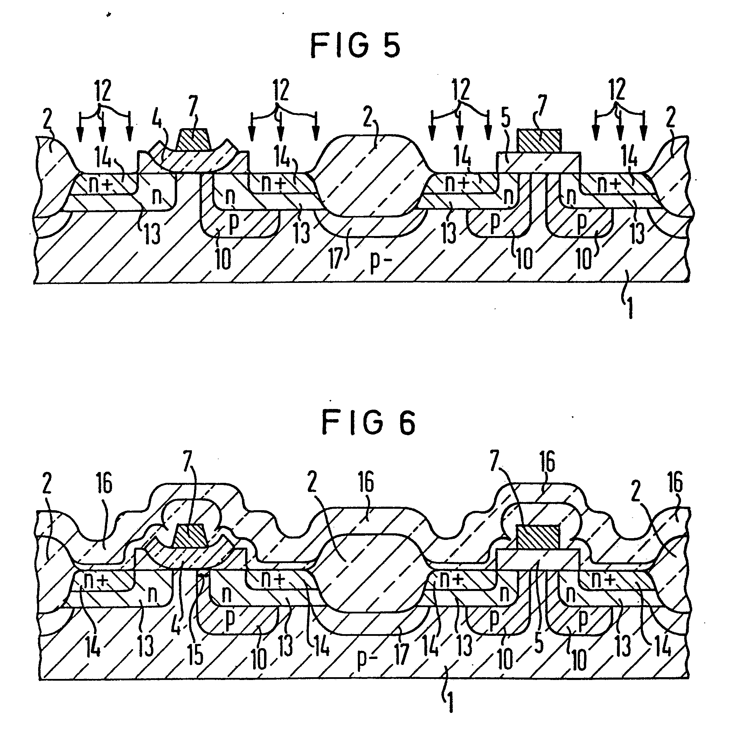

Dann wird nach Ablösung der Fotolackschicht 8 ein Diffusionsprozeß (drive in) durchgeführt, wobei sich, wie aus Fig. 4 ersichtlich ist, die p-dotierten Gebiete 10 ausbreiten und weit unter das Gateoxid 5 und unter die Siliziumnitrid-Schicht 4 vorschieben. Auf diese Anordnung wird dann eine weitere Fotolackschicht 11 (zweite Fototechnik) gebracht und, wie in Fig. 4 gezeigt, so strukturiert, daß das Gateoxid 5 und die Oxinitrid- bzw. Nitridschicht 4 als Implantationsmaske für die erste Implantation der nachfolgenden Doppelimplantation zur Erzeugung der als Source-Drain-Zone wirkenden n-Gebiete (13 und 14) verwendet werden kann.

Diese Doppelimplantation wird — wie in Fig. 5 dargestellt — nach Ablösen der Fotolackschicht 11 mit Arsen-Ionen (siehe Pfeile 12) unterschiedlicher Implantationsenergie und Dosis durchgeführt. Dabei wird zunächst eine Arsen-Ionen-Implantation von $8 \times 10^{15}$ As$^+$cm$^{-2}$ bei 25 keV und dann eine Arsen-Ionen-Implantation von $2 \times 10^{15}$ As$^+$cm$^{-2}$ bei 100 keV durchgeführt, wodurch im Substrat 1 und in den p-dotierten Zonen die n-Gebiete 13 und n$^+$-Gebiete 14 entstehen. Die mit dem Doppelpfeil 15 markierte Stelle zeigt den im Submikron-Bereich liegenden Kanal an.

Nach erfolgter Ausheilung der Implantation wird, wie in Fig. 6 dargestellt, das Zwischenoxid 16 durch thermische Oxidation und LPCVD (=low pressure chemical-vapor-deposition) in einer Dicke von 70 nm aufgebracht und zur Erzeugung von Kontaktlöchern in bekannter Weise strukturiert. Die Metallisierung und die Aufbringung einer Schutzschicht geschieht wie bei bekannten Silizium-Gate-Prozessen.

**Patentansprüche**

1. Verfahren zum Herstellen von MNOS-Speichertransistoren mit sehr kurzer Kanallänge in Silizium-Gate-Technologie, bei dem in einem Halbleitersubstrat eines ersten Leitfähigkeitstyps Source- und Drainzonen von MNOS- und MOS-Bauelementen vom zweiten, zum ersten entgegengesetzten Leitfähigkeitstyp vorgesehen sind und die Ränder der Gate-Elektroden, bezogen auf die Ebene der Substratoberfläche, senkrecht und selbstjustierend über den Rändern der Source- und Drainzonen liegen, wobei die im Substrat erzeugten Source- und Drainzonen unter Verwendung der Gateelektroden als Implantationsmaske durch Ionenimplantation hergestellt werden, gekennzeichnet durch den Ablauf der folgenden Verfahrensschritte für die gleichzeitige Herstellung der MNOS- und MOS-Bauelemente:

a) Erzeugung einer als Tunneloxid wirkenden Siliziumoxidschicht (3) auf einem zur Trennung der aktiven Transistorbereiche mit strukturiertem, als Feldoxid wirkenden SiO₂-Schichten (2) versehenen Siliziumsubstrat (1) eines ersten Leitfähigkeitstyps,

b) ganzflächige Abscheidung einer als Speicherschicht dienenden Siliziumnitridschicht (4),

c) Strukturierung der Speichernitridschicht (4) im Bereich des Speichertransistors,

d) Durchführung einer ganzflächigen Oxidation zur Erzeugung des Gateoxids (5) und einer Oxinitridschicht (6) auf dem Speichernitrid (4),

e) Abscheidung einer Polysiliziumschicht und Strukturierung der Polysiliziumschicht als Gateelektroden (7) im Bereich des Speicher- und des MOS-Transistors,

f) Durchführung einer ersten Fotolacktechnik zur Erzeugung einer Implantationsmaske (8) über den Feldoxidbereichen (2) und über der Gateelektrode des Speichertransistors (4, 6, 7),

g) Durchführung einer ersten Implantation (9) mit Ionen des ersten Leitfähigkeitstyps,

h) Durchführung einer Diffusion nach Ablösung der Fotolackmaske (8) zur Ausbildung der durch die erste Implantation erzeugten Gebiete (10) des ersten Leitfähigkeitstyps,

i) Durchführung einer zweiten Fotolacktechnik zur Erzeugung einer Implantationsmaske (11) im Bereich des Gateoxids (5) für den MOS-Transistor und des Gateoxids (5) mit der Nitrid- (4) bzw. Oxidnitridschicht (6) des Speichertransistors,

j) Durchführung einer Doppelimplantation von Ionen des zweiten Leitfähigkeitstyps (12), wobei zuerst eine Implantation mit niedriger Energie zur Erzeugung von als Source/Drain-Zonen wirkenden n⁺-Gebieten (14) und dann nach Ablösung der Fotolackmaske (11) eine weitere Implantation mit höherer Energie zur Erzeugung ebenfalls als Source/Drain-Zonen wirkender n-Gebiete (13) und eines Kurzkanals (15) des MNOS-Transistors durchgeführt wird,

k) Abscheidung des Zwischenoxids, Erzeugung der Kontaktlöcher und Herstellung der Metallkontakte in bekannter Weise.

2. Verfahren nach Anspruch 1, dadurch gekennzeichnet, daß zur Herstellung eines n-Kanal-MNOS-Speichertransistors als erste Implantation eine Borimplantation mit einer Implantationsdosis von $2 \times 10^{12}$ bis $1 \times 10^{13}$ B⁺cm⁻² und einer Energie von 35 keV und als Doppelimplantation eine Arsenimplantation von zunächst $8 \times 10^{15}$ As⁺cm⁻² und 25 keV und dann von $2 \times 10^{15}$ As⁺cm⁻² und 100 keV durchgeführt wird.

3. Verfahren nach Anspruch 1 und 2, dadurch gekennzeichnet, daß die Dicke der Tunneloxidschicht im Bereich von 2,0 nm bis 3,5 nm liegt und die Dicke der Siliziumnitridschicht für den Speichertransistor auf einen Bereich von 20 nm bis 50 nm, insbesondere 40 nm, eingestellt wird.

**Claims**

1. A process for the production of MNOS storage transistors of very short channel length in the silicon-gate technique, in which, in a semiconductor substrate of a first conductivity type, there are provided source and drain zones of MNOS and MOS components of the second conductivity type which is opposite to the first, and the edges of the gate electrodes, relative to the plane of the substrate surface, are arranged at right angles and in self-aligning manner over the edges of the source and drain zones, the source and drain zones formed in the substrate being produced by ion implantation using the gate electrodes as implantation masks, characterised by the sequence of the following process steps for the simultaneous production of the MNOS and MOS components:

a) production of a silicon oxide layer (3), which acts as a tunnel oxide layer on a silicon substrate (1) of a first conductivity type which in order to separate the active transistor zones is provided with structured SiO₂ layers (2) which serve as field oxide layers;

b) deposition of a silicon nitride layer (4) serving as a storage layer over the entire surface;

c) structuring of the storage nitride layer (4) in the region of the storage transistor;

d) carrying out an oxidation over the entire surface in order to produce the gate oxide (5) and an oxynitride layer (6) on the storage nitride layer (4);

e) deposition of a polysilicon layer and structuring of the polysilicon layer to form gate electrodes (7) in the region of the storage and the MOS transistor;

f) carrying out a first photo-lacquer process to produce an implantation mask (8) over the field oxide regions (2) and over the gate electrode of the storage transistor (4, 6, 7);

g) carrying out a first implantation (9) using ions of the first conductivity type;

h) carrying out a diffusion, after removal of the photo-lacquer mask (8), to extend the zones (10) of the first conductivity type which have been produced by the first implantation;

i) carrying out a second photo-lacquer process to produce an implantation mask (11) in the region of the gate oxide (5) for the MOS transistor and of the gate oxide (5) with the nitride layer (4) and the oxynitride layer (6) of the storage transistor;

j) carrying out a double implantation using ions of the second conductivity type (12) in which implantation is first carried out with low energy in order to form +zones (14) to serve als source/drain zones, and thereafter, after removal of the photo-lacquer mask (11), a further implantation is carried out with higher energy to produce n-zones (13), which also serve as source/drain zones, and to produce a short channel (15) for the MNOS transistor;

k) deposition of the intermediate oxide layer, production of the contact holes, and production of the metal contacts, in known manner.

2. A process as claimed in Claim 1, characterised in that, for the production of an n-channel-MNOS-storage transistor, as first implantation, a boron implantation is carried out with an implantation dosage of $2 \times 10^{12}$ to $1 \times 10^{13}$ B.$^+$cm$^{-2}$ and an energy of 35 keV, and as the double implantation, an arsenic implantation is carried out of, first $8 \times 10^{15}$ As.$^+$cm$^{-2}$ and 25 keV, and then of $2 \times 10^{15}$ As.$^+$cm$^{-2}$ and 100 keV.

3. A process as claimed in Claims 1 and 2, characterised in that the thickness of the tunnel oxide layer is in the range of between 2.0 nm and 3.5 nm, whilst the thickness of the silicon nitride layer for the storage transistor is set in a range of between 20 nm and 50 nm, in particular 40 nm.

**Revendications**

1. Procédé pour fabriquer des transistors de mémoire de type MNOS possédant une longueur de canal très courte suivant la technologie de la porte en silicium, dans lequel, dans un substrat semiconducteur possédant un premier type de conductivité, sont prévues des zones de source et de drain de composants MNOS et MOS possédant le second type de conductivité, opposé au premier, et les bords des électrodes de porte, rapporté au plan de la surface du substrat, sont disposés verticalement et de façon auto-alignée, au-dessus des bords des zones de source et de drain, les zones de source et de drain formées dans le substrat étant fabriquées par implantation d'ions, en utilisant les électrodes de porte comme masque d'implantation, caractérisé par le déroulement des phases opératoires suivantes, pour la fabrication simultanée de composants MNOS et MOS:

a) formation d'une couche d'oxyde de silicium (3), agissant comme oxyde à effet de tunnel, sur un substrat en silicium structuré (1), possédant un premier type de conductivité, qui est muni de couches de SiO$_2$ (2) agissant comme oxyde de champ, pour séparer les régions actives du transistor,

b) dépôt sur toute la surface d'une couche de nitrure de silicium (4) servant de couche de mémorisation,

c) structuration de la couche de nitrure de silicium (4) dans la région du transistor de mémorisation,

d) réalisation d'une oxydation sur toute la surface pour former l'oxyde de porte (5) est une couche d'oxynitrure (6) sur le nitrure de mémorisation (4),

e) dépôt d'une couche de polysilicium et structuration de la couche de polysilicium sous forme d'électrodes de porte (7) dans la région du transistor de mémorisation et du transistor MOS,

f) mise en oeuvre d'une première technique de laque photosensible pour former un masque d'implantation (8) sur les régions d'oxyde de champ (2) et sur l'électrode de porte du transistor de mémorisation (4, 6, 7),

g) réalisation d'une première implantation (9) avec des ions possédant le premier type de conductivité,

h) réalisation d'une diffusion après dissolution du masque de laque photosensible (8) pour développer les régions (10), possédant le premier type de conductivité, formées par la première implantation,

i) mise en oeuvre d'une seconde technique de laque photosensible pour former un masque d'implantation (11) dans la région de l'oxyde de porte (5) pour le transistor MOS et de l'oxyde de porte (5) avec la couche de nitrure (4) ou d'oxynitrure (6) du transistor de mémorisation,

j) réalisation d'une double implantation d'ions possédant le second type de conductivité (12), une implantation étant tout d'abord effectuée avec une énergie faible pour former des régions de type n$^+$ (14) agissant comme zones de source/drain, puis après dissolution du masque de laque photosensible (11), une autre implantation étant effectuée avec une énergie plus importante pour former également des régions de type n (13), agissant comme zones de source/drain, et un canal court (15) du transistor MNOS,

k) dépôt de l'oxyde intermédiaire, formation des trous de contact et fabrication des contacts métalliques de façon connue.

2. Procédé suivant la revendication 1, caractérisé par le fait que pour fabriquer un transistor de mémoire MNOS à canal n, comme première implantation on effectue une implantation de bore avec une dose d'implantation de $2 \times 10^{12}$ à $1 \times 10^{13}$ B$^+$cm$^{-2}$ et une énergie de 35 keV, et comme implantation double on effectue une implantation d'arsenic de tout d'abord $8 \times 10^{15}$ As$^+$cm$^{-2}$ et 25 keV, puis de $2 \times 10^{15}$ As$^+$cm$^{-2}$ et 100 keV.

3. Procédé suivant les revendications 1 et 2, caractérisé par le fait que l'épaisseur de la

9    0 029 554

couche d'oxyde à effet de tunnel se trouve dans la gamme de 2,0 nm à 3,5 nm, et que l'épaisseur de la couche de nitrure de silicium pour le transistor de mémoire est réglée sur une gamme de 20 nm à 50 nm, notamment 40 nm.

FIG 1

FIG 2

FIG 3

FIG 4

# FIG 5

# FIG 6